Europäisches Patentamt

European Patent Office

Office européen des brevets

(19)

(11) Veröffentlichungsnummer : **0 387 525 B1**

## (12) EUROPÄISCHE PATENTSCHRIFT

(45) Veröffentlichungstag der Patentschrift :
**11.08.93 Patentblatt 93/32**

(21) Anmeldenummer : **90102683.1**

(22) Anmeldetag : **12.02.90**

(51) Int. Cl.$^5$ : **C04B 35/00,** H01L 39/24,
B32B 18/00

(54) **Verfahren zur Herstellung einer kristallorientierten Oberflächenschicht aus einem keramischen Hochtemperatur-Supraleiter.**

(30) Priorität : **15.03.89 CH 946/89**

(43) Veröffentlichungstag der Anmeldung :
**19.09.90 Patentblatt 90/38**

(45) Bekanntmachung des Hinweises auf die
Patenterteilung :
**11.08.93 Patentblatt 93/32**

(84) Benannte Vertragsstaaten :
**CH DE FR GB IT LI SE**

(56) Entgegenhaltungen :
**EP-A- 0 292 340**
**EP-A- 0 300 646**

(56) Entgegenhaltungen :
**EP-A- 0 301 655**
**JAPANESE JOURNAL OF APPLIED PHYSICS,**
**Band 27, Nr. 7, Juli 1988, Seiten L1297-L1299;**
**K. HOSHINO et al.: "Preparation of supercon-**
**ducting Bi-Sr-Ca-Cu-O printed thick films on**
**MgO substrate and Ag metal tape"**

(73) Patentinhaber : **ASEA BROWN BOVERI AG**
**Haselstrasse**
**CH-5401 Baden (CH)**

(72) Erfinder : **Greuter, Felix, Dr.**
**Im Tobelacher 11**
**CH-5406 Baden-Rütihof (CH)**
Erfinder : **Schüle, Claus, Dr.**
**Gemeindestrasse 4**
**CH-8967 Widen (CH)**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 387 525 B1

**Beschreibung**

Verfahren zur Herstellung einer kristallorientierten Oberflächenschicht aus einem keramischen Hochtemperatur-Supraleiter

Technisches Gebiet

Technologie der elektrischen Supraleiter. In neuester Zeit nimmt die Bedeutung von Werkstoffen, welche supraleitende Eigenschaften haben, mehr und mehr zu. Die Entdeckung von neuen supraleitenden Werkstoffen, insbesondere des Typs seltene Erden/Ba/Cu/O, führte zu einer beträchtlichen Erweiterung der Anwendungsmöglichkeiten für Supraleiter, da diese Stoffe bereits bei Temperaturen oberhalb 50 K supraleitend werden.

Die Erfindung bezieht sich auf die Weiterentwicklung und Verbesserung von Erzeugnissen aus einem keramischen Hochtemperatur-Supraleiter, wobei den Bedürfnissen der industriellen Grossproduktion Rechnung getragen werden soll.

Insbesondere betrifft die Erfindung ein Verfahren zur Herstellung einer polykristallinen, kristallorientierten Oberflächenschicht auf einem Substrat oder einer Zwischenschicht zwischen zwei Substraten, wobei die besagte Schicht aus einem keramischen Hochtemperatur-Supraleiter auf der Basis von $(Y,SE)$ $Ba_2Cu_3O_{6,5+y}$ mit SE = seltenes Erdmetall und $O<y<1$ besteht.

Stand der Technik

Unter den oxydischen Hochtemperatur-Supraleitern scheinen die Ythium, Barium und Kupfer enthaltenden Verbindungen besonders erfolgversprechend zu sein. Gegenüber den klassischen metallischen beziehungsweise intermetallischen Supraleitern steht ihrer Verwendung jedoch die Sprödigkeit, schwierige Verarbeitbarkeit und vor allem mangelhafte Stromtragfähigkeit (niedrige kritische Stromdichte $j_c$ hindernd im Wege. Die Oxydverbindung $YBa_2Cu_3O_{6,5+y}$ ($O<y<1$) ist ein Supraleiter mit der kritischen Temperatur $T_c = 93$ K, wenn sie in der orthorhombischen Modifikation vorliegt und y ca. 0,4 bis 0,5 beträgt. Erzeugt man eine einkristalline dünne Schicht (d = 50 - 500 nm) durch Aufdampfen oder Kathodenzerstäubung, so findet man maximale kritische Stromdichten $j_c \approx 5 \times 10^6$ A/cm² (bei 77 K und Magnetfeld H = 0) parallel zur Schichtebene wenn die Schicht mit ihrer orthorhombischen c-Achse senkrecht zur schichtebene orientiert ist. Diese Orientierung erhält man, wenn als Substrat ein Einkristall von $SrTiO_3$ benutzt wird, dessen Oberfläche so orientiert ist, dass die <100> Richtung seiner kubischen Struktur senkrecht zur Oberfläche steht. Ausserdem müssen Substrattemperatur und Atmosphäre in der Beschichtungsapparatur geeignet gewählt werden. Andererseits wurden für polykristalline, massive Keramiken nur kritische Stromdichten von maximal $j_c \approx 1000$ A/cm² (T = 77 K, H = 0) erhalten, auch bei optimalen Herstellungsbedingungen. Als Ursache für diese, die technische Anwendungen stark einschränkenden, starke Reduktion von $j_c$ in polykristallinen Keramiken hat man die schwache Kopplung der Supraleitungsströme über Korngrenzen hinweg erkannt. Ferner ist bekannt, dass in dieser Hinsicht die Korngrenzen senkrecht zur c-Achse besonders ungünstige Wirkung haben, während die Korngrenzen senkrecht zur a- oder b-Achse viel grösere Supraleitungsströme tragen können. Es hat daher nicht an Versuchen gefehlt Keramiken, und insbesondere polykristalline Schichten aus oben genanntem Material zu erzeugen, deren Kristallite möglichst vollständig so ausgerichtet sind, dass in der Richtung des supraleitenden Stromes keine Korngrenzen vorkommen die den Strom stark reduzieren. Alle Kristallite müssen dann also ihre c-Achse senkrecht zur Substratoberfläche haben, während die a- und b-Achsen beliebig orientiert sein können. Es wurden nun zwar schon Schichten hergestellt, deren Kristallite zum Teil in dieser Art orientiert waren, doch erhielt man bisher nur enttäuschend geringe kritische Stromdichten, maximal 70 A/cm² also weniger als 1/10 dessen, was an den besten unorientierten Keramiken gefunden wurde. Dieses ungenügende Ergebnis lässt sich z.T. aus der Verwendung von ungeeigneten Substraten erklären, die beim Sintern der supraleitenden Substanz in unerwünschter Weise reagieren und die Korngrenzen durch artfremde Phasen verunreinigen.

Zum Stand der Technik werden folgende Literaturstellen zitiert:
- F.Kloucek, W.E. Rhine, H.K. Bowen, "Thick films of $YBa_2Cu_3O_x$ fabricated from colloidal solutions", Internat. Conf. on High-$T_c$ Superconductors, Interlaken 1988
- P. Murugaraj et al., "Preparation of highly oriented Polycristalline $YBa_{2-y}Cu_3O_x$ Superconductors", solid State Communications, vol. 66, No. 7, 1988, pp. 735-738
- Tadashi Takenaka, Hideki Noda, Atsuhiko Yoneda and Koichiro Sakata, "Superconducting Properties of Grain-Oriented $YBa_2Cu_3=_{7-x}$ Ceramics", Japanese Journal of Applied Physics, Vol. 27, No. 7, 1988, pp. L1209-L1212

2

- Junji Tabuchi and Kazuaki Utsumi, "Preparation of superconducting Y-Ba-Cu-O thick films with preferred c-axis orientation by a screen-printing method", Appl. Phys. Lett 53(7), 15 August 1988
- J.T. Markert, B.D. Dunlap, and M.B. Maple, "Magnetism, Superconductivity, and Chemical Substitutions in $YBa_2Cu_3O_{7-\delta}$", MRS Bulletin/January 1989.

Die nach den bekannten Verfahren hergestellten supraleitenden Keramikschichten genügen den heutigen Anforderungen bei weitem nicht. Es besteht daher ein grosses Bedürfnis nach Verbesserung und Weiterentwicklung derartiger Schichten.

## Darstellung der Erfindung

Der Erfindung liegt die Aufgabe zugrunde, ein Verfahren zur Herstellung einer kristallorientierten Oberflächenschicht aus einem keramischen Hochtemperatur-Supraleiter auf der Basis von $(Y,SE)Ba_2Cu_3O_{6,5+y}$ mit SE = seltenes Erdmetall und $0<y<1$, anzugeben, welches sich auf einfache Weise durchführen lässt und reproduzierbare Ergebnisse liefert, dergestalt, dass eine optimale Orientierung der c-Achse der Kristallite dieser polykristallinen Schicht der supraleitenden Substanz unter allen Umständen gewährleistet ist. Die nach dem Verfahren hergestellten supraleitenden Oberflächenschichten sollen eine Dicke von mindestens 10 μm und eine kritische Stromdichte (Stromtragfähigkeit) von mindestens $10^3$ A/cm² aufweisen.

Diese Aufgabe wird dadurch gelöst, dass im eingangs erwähnten Verfahren als Substrat reines metallisches Silber oder eine bis zu 20 Gew.-% Au oder Pd oder Pt enthaltende Silberlegierung benutzt wird und dass auf das besagte Substrat eine aus den einfachen Oxyden und/oder Mischoxyden der Elemente Y, Ba, Cu oder den Oxyden der Elemente Y und Cu und dem Karbonat des Ba bestehende, das stöchiometrische Verhältnis Y:Ba:Cu:O = 1:2:3:6,5 entsprechende erste Pulverschicht von höchstens 5 μm Dicke mit Partikeln von < 2 μm Durchmesser aufgetragen und darauf eine zweite Pulverschicht bestehend aus 1 bis 10 Mol% aus der vorgenannten Pulvermischung, Rest Pulver aus der supraleitenden Substanz $(Y,SE) Ba_2Cu_3O_{6,5+y}$ in einer Dicke von 5 bis 50 μm aufgebracht und das Ganze in einer Atmosphäre von mindestens 20 Vol.-% $O_2$, Rest $N_2$ oder ein inertes Gas unter einem totalen Gasdruck von mindestens 1 bar bei einer Sintertemperatur von mindestens 885 °C und höchstens 927 °C gesintert wird, indem das Ganze zunächst mit einer Geschwindigkeit von höchstens 50 °C/h auf 400 °C, dann mit einer solchen von höchstens 300 °C/h auf Sintertemperatur erhitzt, bei dieser während 30 min gehalten wird, wobei in der Schicht vorübergehend 0,1 bis 5 Vol.-% einer flüssigen Phase gebildet werden, und dass das Ganze mit einer Geschwindigkeit von höchstens 100 °C/h auf 600 bis 400 °C abgekühlt, bei dieser Temperatur während 2 h gehalten und schliesslich mit einer Geschwindgkeit von höchstens 100 °C/h auf Raumtemperatur abgekühlt wird.

## Weg zur Ausführung der Erfindung

Die Erfindung wird anhand der nach folgenden, durch Figuren näher erläuterten Ausführungsbeispiele beschrieben.

Dabei zeigt:

Fig. 1     ein Fliessbild (Blockdiagramm) des Verfahrens zur Herstellung einer kristallorientieren Oberflächenschicht aus einem keramischen Hochtemperatur-Supraleiter,

Fig. 2     ein schematischer (metallographischer) Schnitt durch auf ein Substrat aufgebrachte Pulverschichten vor dem Sintern,

Fig. 3     ein schematischer (metallographischer) Schnitt durch eine auf ein Substrat aufgebrachte supraleitende Oberflächenschicht nach dem Sintern.

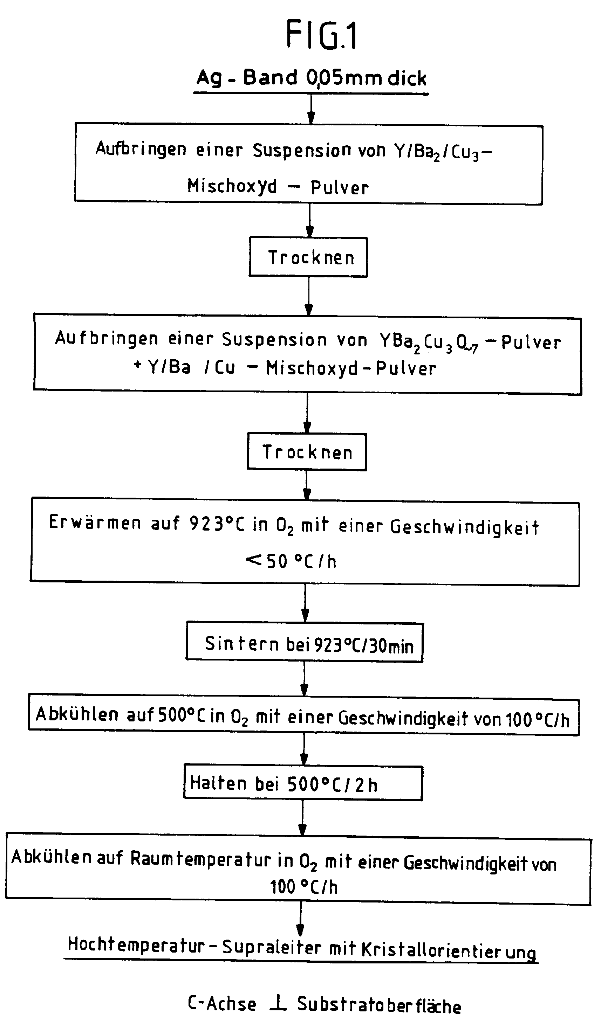

In Fig. 1 ist ein Fliessbild (Blockdiagramm) des Verfahrens zur Herstellung einer kristallorientierten Oberflächenschicht aus einem keramischen Hochtemperatur-Supraleiter dargestellt. Im vorliegenden Fall handelt es sich um die Erzeugung einer Schicht aus der supraleitenden Substanz $YBa_2Cu_3O_{\approx 7}$ auf einem Ag-Substrat. Das Diagramm bedarf keiner weiteren Erklärungen. Das Aufbringen der 1. und 2.

Pulvermischung kann durch wiederholtes Tränken in der Suspension und Trocknen erfolgen.

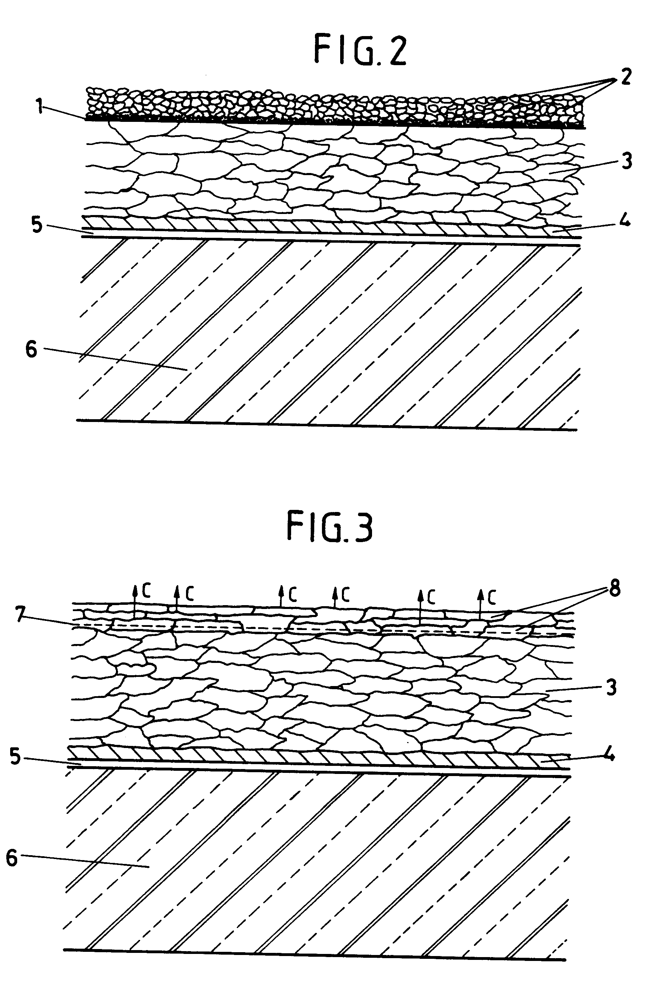

Fig. 2 bezieht sich auf einen schematischen (metallographischen) Schnitt durch auf ein Substrat aufgebrachte Pulverschichten vor dem Sintern. 1 stellt eine 1. Pulverschicht aus Oxydmischungen und Mischoxyden mit einem stöchiometrischen Verhältnis der Elemente Y:Ba:Cu:O = 1:2:3:6,5 dar. Diese 1. Pulverschicht wird direkt auf das Substrat 3 in Form eines Ag-Bleches oder Bandes aufgebracht. Ueber dieser 1. Pulverschicht 1 liegt die danach aufgebrachte 2. Pulverschicht 2, im wesentlichen aus supraleitender Substanz der Zusammensetzung $YBa_2Cu_3O_{\approx 7}$. 6 ist ein Träger aus einem Konstruktionswerkstoff der mindestens die Sintertemperaturen (max. ca. 930 °C) aushält ohne sich zu verändern oder zu deformieren. Im vorliegenden Fall bedeutet 6 ein Stab oder eine Platte aus $SiO_2$. 5 ist eine als Haftvermittler dienende Cr-Schicht. 4 ist eine dünne Schicht aus Pd, welche zum eigentlichen Substrat 3 überleitet.

In Fig. 3 ist ein schematischer (metallographischer) Schnitt durch eine auf ein Substrat aufgebrachte supraleitende Oberflächenschicht nach dem Sintern dargestellt. Die Bezugszeichen 3, 4, 5 und 6 entsprechen genau denjenigen der Fig. 2. Unmittelbar an die Grenzfläche des Substrates 3 schliesst die Zone 7 der transienten flüssigen Phase an, die im Verlauf der Wärmebehandlung vorübergehend gebildet wird. Diese Zone ist symbolisch durch eine gestrichelte Linie angedeutet. Selbstverständlich kann sie sich vor allem entlang der Korngrenzen der supraleitenden Substanz weiter in die letztere hinein erstrecken. 8 ist die fertige polykristalline, kristallorientierte Oberflächenschicht aus der supraleitenden Substanz $YBa_2Cu_3O_{\approx7}$, deren Kristallite derart orientiert sind, dass ihre c-Achsen senkrecht auf der Substratoberfläche stehen. Dies ist durch Pfeile c, die in verschiedenen Lagen ihren Ursprung haben, angedeutet.

Allgemeines:

Der Kern der Erfindung besteht im wesetnlichen in zwei kennzeichnenden Merkmalen:
1. Verwendung von Ag oder einer Ag-reichen Legierung als Substrat.
2. Vorübergehende Herstellung einer "transienten" flüssigen Phase als Sinterhilfe, die sich im Verlauf des Sinterprozesses in supraleitende Substanz umwandelt, ohne Fremdstoffe zurückzulassen.

Flüssige Phasen der vorgenannten Art bilden sich im binären System $Y_2O_3/BaO/CuO$, wenn feinverteilte Pulver der Ausgangsstoffe auf Temperaturen von 915 - 940 °C gebracht und unter O2-Druck von 1 bar miteinander zur Reaktion gebracht werden.

Beispielsweise beginnt die Reaktion

$$Y_2Cu_2O_5 + 4BaCuO_2 -> 2YBa_2Cu_3O_{6,5+y}$$

oberhalb von 920 °C unter Bildung einer flüssigen Phase, die im wesentlichen aus dem Eutektikum zwischen $BaCuO_2$ und $CuO$ besteht. Im weiteren Verlauf dieser Reaktion entsteht zunehmend $YBa_2Cu_3O_{6,5+y}$ bis zuletzt die Ausgangsstoffe völlig in diese Phase umgewandelt worden sind. Die flüssige Phase entsteht an den Kontaktstellen der Pulverkörner von $Y_2Cu_2O_5$ und $BaCuO_2$ und beschleunigt die Reaktion der beiden festen Ausgangsphasen zu festem $YBa_2Cu_3O_{6,5+y}$. Ausserdem fördert die flüssige Phase die Kristallisation des Reaktionsproduktes sehr stark. Nach Reaktionsablauf erhält man einen polykristallinen Sinterkörper der dicht und weitgehend porenfrei ist und vollständig aus gut kristallisiertem, einphasigem $YBa_2Cu_3O_{6,5+y}$ besteht. Die vorübergehend entstandene flüssige Phase verschwindet also quantitativ wieder.

In analoger Weise reagieren andere Ausgangsstoffe z.B.:

$$Y_2O_3 + 4BaCO_3 + 6CuO -> 2YBa_2Cu_3O_{6,5+y} + 4CO_2$$

wobei das gasförmige $CO_2$ als Nebenprodukt austritt
oder

$$Y_2BaCuO_5 + 3BaCuO_2 + 2CuO -> 2Yba_2Cu_3O_{6,5+y}$$

Hierbei entsteht kein Nebenprodukt.

Die Verwendung von Reaktionen ohne Nebenprodukte ist bevorzugt, weil damit phasenreines Material erhalten wird und die Bildung von Poren durch eingeschlossene Gase vermieden wird. Für die Herstellung von dichtgesintertem Material ist es wichtig, den Volumenanteil an flüssiger Phase auf 0,1 - 5 % zu begrenzen. Zu viel flüsige Phase führt zu lokalen Entmischungsvorgängen und inhomogenen, nicht phasenreinen Sinterkörpern. Es hat sich als schwierig erwiesen, den Volumenanteil der flüssigen Phase während des Reaktionsverlaufes nach Wunsch zu steuern, z.B. durch präzise Temperaturkontrolle. Die Steuerung kann aber einfach erreicht werden durch Verwendung einer Pulvermischung die zum überwiegenden Teil aus fertig reagiertem $YBa_2Cu_3O_{6,5+y}$ Pulver besteht dem ein Anteil von noch unreagierten Ausgangspulvern im richtigen stöchiometrischen Verhältnis zugefügt wird, z.B. 90 Gew.-% $YBa_2Cu_3O_{6,5+y}$ + 10 Gew.-% ($Y_2Cu_2O_5 + 4BaCuO_2$).

Die Herstellung und Verarbeitung der Pulver muss in inerter Atmosphäre, insbesondere unter Ausschluss von Wasser und $CO_2$ erfolgen weil $YBa_2Cu_3O_{7-\delta}$, $Y_2Cu_2O_5$, $Y_2BaCuO_5$ und $BaCuO_2$ mit diesen Stoffen rasch reagieren und zersetzt werden, unter Bildung von $BaCO_3$ bzw. $Ba(OH)_2$. Die beschriebenen Pulver lassen sich einfach in inerten Flüssigkeiten dispergieren und aus den Suspensionen als Schichten abscheiden. Geeignete Suspensionen erhält man z.B. durch Verarbeiten von Ausgangspulvern zusammen mit Isopropanol (Wassergehalt <0,01 Vol.-%) und Zusatz von 2 Gew.-% Hydroxypropylzellulose (MG 300 000), bezogen auf das Pulvergewicht. Die Teilchengrösse der Pulver sollte unterhalb von 2 $\mu$m liegen, vorzugsweise zwischen 0,8 $\mu$m und 0,1 $\mu$m. Das lässt sich einfach erreichen durch Klassieren der Pulversuspensionen z.B. mit Hilfe einer Zentrifuge. Enge Partikelgrössenverteilung im Bereich 0,8 $\mu$m bis 0,1 $\mu$m ist erforderlich damit die abgeschiedenen Pulverschichten dichte Packung und damit hohe Gründichte erhalten. Lose Packung und geringe Gründichten (<50 % der theoretischen Dichte) führen zu hoher Schwindung und Rissbildung in den Schichten beim Sintern.

Im allgemeinen wird auf Ag-Substrat eine erste Schicht aus den Ausgangspulvern und eine zweite Schicht aus Pulver der supraleitenden Substanz (inkl. geringe Anteile Zusatz des ersten Pulvers) aufgetragen und jeweils getrocknet. Das Substrat mit daraufliegender Pulverschicht wird nun in einem Ofen gesintert, der von Sauerstoff von 1 bar Druck durchströmt ist. Zunächst wird die Temperatur langsam (50 °C/h) auf 400 °C erhöht, um das Pulverteilchen anhaftende Suspensionsmittel auszubrennen. Dann steigert man die Temperatur auf 923 °C mit 300 °C/h und hält die Temperatur dort während 30 Minuten. Hierbei sintert die Schicht unter der Wirkung der sich vorübergehend bildenden flüssigen Phase die nahe der Grenzfläche Silber/Pulver mit hohem Volumenanteil aus $Y_2Cu_2O_5$ + $4BaCuO_2$ entsteht, in der übrigen Schicht aber mit geringerem Volumenanteil, weil dort nur 10 Gew.-% der reaktionsfähigen Pulvermischung vorhanden ist. Die sich an der Grenzfläche durch reaktion rasch bildenden Kristallite aus $YBa_2Cu_3O_{6,5+y}$ sind nun überraschenderweise so orientiert, dass ihre c-Achse senkrecht zur Substratoberfläche steht. Die Kristallbildung und Sinterung im restlichen Volumen geht etwas langsamer vor sich, und orientiert sich an den vorgängig gebildeten Kristallen nahe der Substratoberfläche. Es wachsen also vorzugsweise Kristallite mit gleicher Orientierung.

Auf diese Weise hergestellte Schichten auf Silbersubstraten sind etwa 10 µm dick; sie bestehen aus einem dichten Gefüge von Kristallen deren c-Achse grösstenteils senkrecht zur Substratoberfläche steht und deren a- und b-Achsen regellos parallel zur Substratoberfläche liegen. Die kritische Temperatur der supraleitenden Schichten beträgt 90 - 93 K. Die Orientierung der Kristallite kann durch Röntgenstrahlbeugung festgestellt werden. Man lässt dazu den Primärstrahl in azimutaler Richtung zur Substratoberfläche einfallen. Das Beugungsspektrum enthält dann bei vollkommener Orientierung von c Substrat nur Reflexe der Indizierung (0 0 1). Fig. 1 zeigt das Beugungsspektrum eifner nach dem oben beschriebenen Verfahren erzeugten YBaCO Schicht und bestätigt die hervorragend gute Orientierung der Kristallite.

Je nach Grad vorangegangener Kaltverformung rekristallisiert Silber im Bereich von 600 bis 900 °C, was für die nachher aufgebrachte Supraleiterschicht wegen dadurch verursachter Unebenheiten und ungünstiger Kristallorientierung von Nachteil sein kann. Dieser unerwünschte effekt wird weitgehend unterdrückt, wenn statt reinem Silber eine silberreiche Legierung mit einem höheren Schmelzpunkt als Silber verwendet wird. Es wurde gefunden, dass Legierungen mit Palladium vorteilhaft sind. Besonders im Bereich 95 Mol % Ag / 5 Mol % Pd bis 80 Mol % Ag / 20 Mol % Pd wird einerseits keine erhebliche Reaktion mit der supraleitenden Substanz beobachtet, andererseits ist die Rekristallisation der Legierung viel weniger ausgeprägt als bei reinem Silber. Legierungen mit Gold und Platin sind ebenfalls geeignet aber erheblich teurer.

Aus Kostengründen ist es für die Praxis wünschenswert, das Substratmaterial Silber teilweise durch preisgünstigere Stoffe zu ersetzen. Es kommen dafür Metalle und Legierungen in Frage, deren Schmelzpunkte höher sind als 960 °C und die mit Silber keine tieferschmelzenden Legierungen, Eutektika oder Verbindungen bilden. Ausserdem müssen geeignete Metralle hinreichend oxidationsbeständig und zunderfest in der Sinteratmosphäre sein. Beispiele geeigneter Metalle sind Ni und hochtemperaturbeständige Ni/Cr-Legierungen. Zur Verwendung als Substrate werden diese Metalle mit einer Schicht (5 - 50 µm) aus Silber oder silberreicher Legierung plattiert, z.B. elektrochemisch. Es ist günstig, zwischen Silber und Basismetallen eine Zwischenschicht (0,1 - 2 µm) aus Palladium anzubringen, wodurch die Haftung verbessert und die Oxydation reduziert wird. Statt auf Metalle können Substrate aus Silber oder silberreicher Legierung auch auf geeignete Träger aus Nichtmetallen aufgebracht werden, um mechanisch stabile Strukturen mit möglichst geringer Verwendung von Silber zu erzielen. Beispielsweise können 50 µm dicke Silberfolien auf 0,6 mm dicke Platten aus $Al_2O_3$-Keramik wärmebeständig befestigt werden durch Verbinden mit einer dünnen Zwischenschicht aus Glas. Dazu überzieht man die Keramikoberfläche dünn (10 µm) mit feinem Pulver aus einem hochschmelzenden Glas, z.B. Pyrex (Fa. Corning, USA), legt die Silberfolie darauf und erhitzt die Komposition für einige Minuten auf 900 °C. So hergestellte Verbundwerkstoffe sind als Substrat/Träger gleich gut geeignet wie die reinen Silberfolien.

An Stelle von $YBa_2Cu_3O_{6,5+y}$ können andere Supraleiter mit der gleichen Struktur aber substituierten Komponenten verwendet werden. Mögliche Varianten mit kritischen Temperaturen $T_s \approx 90$ K sind zahlreich in der Literatur beschrieben worden. Es kann in $YBa_2Cu_3O_{6,5+y}$ zunächst Y ganz oder teilweise ersetzt werden durch La, Nd, Eu, Gd, Tb, Dy, Ho, Er, Tm und Lu. Ferner kann Cu teilweise ersetzt werden durch Fe (< 0,5 %), Ga (< 0,1 %) und Al (< 3 %). Es sind noch zahlreiche weitere Substitutionen möglich, welche im Rahmen dieser Erfindung zur Herstellung von supraleitenden Schichten mit Kristallorientierung herangezogen werden können.

Ausführungsbeispiel 1:

Zunächst wurden drei verschiedene Metalloxydverbindungen (Mischoxyde) in Pulverform hergestellt.
    a) $YBa_2Cu_3O_{\approx 7}$
    b) $Y_2CuO_5$
    c) $BaCuO_2$
Es wurden jeweils stöchiometrische Mengen von Yttriumoxalat, Bariumoxalat und Kupferoxalat (handelsüblich, Reinheit 99,99 %) abgewogen und in eine verschliessbare Flasche aus Polyäthylen gegeben. Dazu fügte man 4 Gewichtsteile Wasser (doppel destilliert) und 4 Gew.-%, bezogen auf den Feststoff, des Tensids Dolapix PC21 (Fa. Zschimmer und Schwarz, BRD) sowie soviel $NH_4OH$-Lösung, dass der $p_H$-Wert der Suspension sich auf 6,9 - 7 einstellte. Dann wurde die Suspension in eine auf dem Unterwassertauschprinzip beruhende, hohe Stossenergien auslösende Zerkleinerungsapparatur ("Microfluidizer M-110" der Fa. Microfluidies Corporation, 90 Oak Street, Newton, MA 02164, USA) gegeben. Dann wurde die Suspension mit Hilfe eines Sprühtrockners (Fa. Büchi, Schweiz, Mini Spray Dryer 190) zu einem trockenen Pulver versprüht. Dieses Pulver wurde in einen Rohrofen gebracht, in dem eine Atmosphäre von 90 Vol.-% $N_2$ und 10 Vol.-% $O_2$ aufrecht erhalten wurde. Das Pulver wurde mit eifner Geschwindigkeit von 50 °C/h auf 800 °C erhitzt und bei dieser Temperatur während 25 h zur Reaktion gebracht und dann in reiner Sauerstoffatmosphäre ($O_2$ = 1 bar) mit 50 °C/h abgekühlt. Nach dem Abkühlen wurde das Produkt sofort in eifne inerte, wasser- und $CO_2$-freie Atmosphäre transferiert (handelsübliche Handschuhbox). Alle folgenden Prozesse wurden darin ausgeführt. Die Prüfung mit Röntgenbeugung zeigte, dass die gewünschten Substanzen praktisch phasenrein vorlagen.

Nun wurden 500 g $YBa_2Cu_3O_{\approx7}$-Pulver in eine verschliessbare Polyäthylenflasche gegeben, dazu 2000 ml wasserfreies Isopropanol ($H_2O$ < 0,01 Gew.-%) und 10 g Hydroxypropylzellulose (MG 300 000). Dann wurde die Suspension in der oben erwähnten Zerkleinerungsapparatur ("Microfluidizer M-110") weiterbehandelt und daraufhin zur Partikelklassierung während 24 h stehengelassen. Die obere Hälfte des Volumens wurde dekantiert. Dieser Teil der Suspension enthielt 99 Gew.-% Partikel im Grössenbereich von 0,8 bis 0,1 μm.

In analoger Weise wurde Pulver und Suspensionen der anderen beiden Verbindungen gemäss b) und c) hergestellt. Dann wurde der Feststoffgehalt der Suspensionen aus einer jeweiligen Teilmenge durch Abdampfen der Flüssigkeit gravimetrisch als Mol Mischoxyd pro Gramm Suspension bestimmt. Durch Mischen der nach obigem Verfahren hergestellten Suspensionen wurden die nachfolgenden, den Pulverschichten 1 und 2 entsprechenden Beschichtungssuspensionen zubereitet. Dabei wurde der jeweilige molare Feststoffgehalt den Mengenverhältnissen zugrunde gelegt:

1. Suspension für Vorbeschichtung mit der Zusammensetzung 0,1 Mol $Y_2CuO_5$ + 0,4 Mol $BaCuO_2$ (Pulverschicht 1)

2. Suspension für Nachbeschichtung mit der Zusammensetzung 0,3 Mol $YBa_2Cu_3O_{\approx7}$ + 0,01 Mol $Y_2CuO_5$ + 0,04 Mol $BaCuO_2$ (Pulverschicht 2)

Als Substrate 3 wurden 50 μm dicke Bänder aus einer Legierung von 90 Mol % Silber und 10 Mol % Palladium in Streifen von 10 mm Breite und 200 mm Länge geschnitten. Diese Bänder wurden einseitig ätzpoliert mit Hilfe einer Polierscheibe die mit Nylontuch überzogen war. Als Aetzmittel diente eine Lösung, die auf 800 ml Wasser 100 ml gesättigte $CrO_3$-Lösung in Wasser und 45 ml HCl (10 %) enthielt. In 2 min wurde ca. 4 μm Metall abgetragen. Anschliessend wurden die Bänder in doppelt destilliertem Wasser abgespült, getrocknet und mit einer Oberfläche auf eine 100 μm dicke Mylarfolie geklebt.

Zur ersten Beschichtung (Pulverschicht 1) tauchte man die Bänder senkrecht in die Vorbeschichtungssuspension, die zuvor durch Zugabe von wasserfreiem Isopropanol auf eine Konzentration von 10 g Feststoff pro 100 ml eingestellt wurde. Mit Hilfe einer Vorrichtung die in inerter, wasser- und $CO_2$-freier Atmosphäre stand, zog man die Bänder mit einer Geschwindigkeit von 10 cm/min senkrecht nach oben heraus und trocknete die anhaftende Schicht bei 80 °C. Die Belegung war etwa 2 mg/cm2. Anschliessend erfolgte die Beschichtung mit der Nachbeschichtungssuspension (Pulverschicht 2) in gleicher Weise, und man wiederholte diese Beschichtung bis die Belegung 6 mg/cm2 betrug.

Die beschichteten Bänder 3 wurden nun von der Mylarfolie abgezogen, auf $Al_2O_3$-Keramikunterlagen mit der Pulverschicht nach oben positioniert und von der Handschuhbox in einen Rohrofen überführt, der von $O_2$ mit 1 bar durchströmt wurde. Bei diesem Transfer dürfen die Schichten nur sehr kurz der Raumatmosphäre ausgesetzt werden. Man steigerte die Ofentemperatur auf 400 °C mit einer Geschwindigkeit von 50 °C/h, dann mit 300 °C/h auf 923 °C und hielt die Temperatur dort während 30 min. Dann kühlte man mit einer Geschwindigkeit von 100 °C/h auf 500 °C ab, hielt dort für 2 h und kühlte wieder mit 100 °C/h auf Raumtemperatur ab.

Die fertigen Schichten waren gut orientiert, etwa 10 μm dick, hatten ein $T_c$ = 92 K und eine kritische Stromdichte $j_c$ = 1800 A/cm2 (77 K, H = 0).

Ausführungsbeispiel 2:

Gemäss Beispiel 1 wurden entsprechende Pulver von Mischoxyden hergestellt. Für die Herstellung der Pulverschichten 1 und 2 wurden Suspensionen der jeweils gleichen molaren Zusammensetzung bereitgestellt. Statt durch Tauchen erfolgte die Beschichtung im vorliegenden Fall jedoch mittels Elektrophorese. Zunächst wurde auf einen Träger 6 aus einer Nickelbasis-Superlegierung mit dem Handelsnamen IN 625 (Inco) in Form eines Bleches von 2 mm Dicke nach entsprechender Reinigung elektrochemisch eine 300 nm dicke Pd-Schicht 4 abgeschieden. Die Superlegierung hatte die nachfolgende Zusammensetzung:

6

```
Cr   =    21,5      Gew.-%
Mo   =     9,0      Gew.-%
Nb   =     3,6      Gew.-%
Al   =     0,2      Gew.-%
Ti   =     0,2      Gew.-%
Fe   =     2,5      Gew.-%
Mn   =     0,2      Gew.-%
Si   =     0,2      Gew.-%
C    =     0,05     Gew.-%
Ni   =    Rest
```

Auf die Pd-Schicht 4 wurde nun elektrochemisch eine Ag-Schicht von 5 μm Dicke als eigentliches Substrat aufgebracht. Der Rand der Ag-Schicht 3 sowie die Schmalseiten und die Rückseite des Trägers 6 wurden mit Klebband abgedeckt und das Ganze senkrecht in ein Elektrophoresebad gestellt. Als Ausgangsstoff für die Elektrophorese wurden Suspensionen verwendet, die mit wasserfreiem Isopropanol derart verdünnt worden waren, dass ihr Feststoffgehalt noch 2 g/100g Suspension betrug. Parallel zu diesem Körper wurde auf der der Ag-Schicht 3 gegenüberliegenden Seite in einem Abstand von 3 cm ein Silberblech als Gegenelektrode aufgestellt. An diese Elektroden wurde eine elektrische Potentialdifferenz angelegt, derart, dass das Substrat 3 als Anode (+) und das Silberblech als Kathode (-) wirkte. Die Spannung wurde so eingestellt, dass ein Strom mit einer Stromdichte von 100 μA/cm² Substratoberfläche floss. Nachdem die 1. Pulverschicht 1 aus Oxydmischungen und Mischoxyd eine Dicke von 3 μm erreicht hatte, wobei ihre Dichte ca. 50 % des theoretischen Wertes betrug, wurde der beschichtete Körper aus dem Bad herausgenommen und bei 80 °C in inerter Atmosphäre getrocknet. Dann wurde die 2. Pulverschicht 2 aus $YBa_2Cu_3O_{\approx 7}$ in gleicher Weise in einer Dicke von 5μm aufgebracht, getrocknet und dieser Verfahrensschritt noch zweimal wiederholt. Die elektrophoretische Beschichtung muss ebenso wie die übrigen Prozesse in inerter, wasser- und $CO_2$-freier Atmosphäre ausgeführt werden.

Nach erfolgter Beschichtung und Trocknung wurde der Körper zwecks Sinterung der Oberflächenschicht 8 analog Beispiel 1 wärmebehandelt. Die nach diesem beispiel erzeugten Sinterschichten waren ebenfalls gut orientiert. Sie hatten ein $T_c$ = 91 K und eine kritische Stromdichte $j_c$ = 2100 A/cm² (77 K, H = 0).

Ausführungsbeispiel 3:

Es wurde zunächst genau gleich wie in Beispiel 1 vorgegangen, wobei je eine Suspension für die Vorbeschichtung und eine für die Nachbeschichtung hergestellt wurde. Als Träger 6 diente ein Flachstab aus Quarz $SiO_2$ von 20 mm Breite und 4 mm Dicke. Zunächst wurde auf diesen Stab rundherum eine 100 nm dicke Cr-Schicht 5 als Haftvermittler mittels Kathodenzerstäubung aufgebracht. Dann wurde der Stab elektrochemisch mit einer Pd-Schicht 4 von 500 nm Dicke versehen, auf welche ihrerseits eine Pd/Ag-Schicht (5 Gew.-% Pd, 95 Gew.-% Ag) von 10 μm Dicke als eigentliches Substrat 3 elektrochemisch abgeschieden wurde. Nach dem Waschen und Trocknen des beschichteten Trägers 6 wurde auf dessen Substrat 3 analog Beispiel 2 elektrophoretisch eine Schichtfolge aufgebracht und zu einer polykristallinen, kristallorientierten Oberflächenschicht aus supraleitender Substanz $YBa_2Cu_3O_{\approx 7}$ gesintert. Bei einer kritischen Temperatur Tc = 90,5 K wurde eine kritische Stromdichte jc = 2200 A/cm² (77 K, H = 0) erzielt.

Die Erfindung ist nicht auf die Ausführungsbeispiele beschränkt.

Das Verfahren zur Herstellung einer polykristallinen, kristallorientierten Oberflächenschicht 8 auf einem Substrat 3 oder einer Zwischenschicht zwischen zwei Substraten 3, wobei die besagte Schicht aus einem keramischen Hochtemperatur-Supraleiter auf der Basis von $(Y,SE)Ba_2Cu_3O_{6,5+y}$ mit SE = seltenes Erdmetall und O<y<1 besteht, wird durchgeführt, indem als Substrat 3 reines metallisches Silber oder eine bis zu 20 Gew.-% Au oder Pd oder Pt enthaltende Silberlegierung benutzt und auf das besagte Substrat 3 eine aus den einfachen Oxyden und/oder Mischoxyden der Elemente Y, Ba, Cu oder den Oxyden der Elemente Y und Cu und dem Karbonat des Ba bestehende, dem stöchiometrischen Verhältnis Y:Ba:Cu:O = 1:2:3:6,5 entsprechende erste Pulverschicht 1 von höchstens 5 μm Dicke mit Partikeln von höchstens 2 μm Durchmesser aufgetragen und darauf eine zweite Pulverschicht 2 bestehend aus 1 bis 10 Mol % aus der vorgenannten Pulvermischung, Rest Pulver aus der supraleitenden Substanz $(Y,SE)Ba_2Cu_3O_{6,5+y}$ in einer Dicke von 5 bis 10 μm aufgebracht

und das Ganze in einer Atmosphäre von mindestens 20 Vol.-% $O_2$, Rest $N_2$ oder ein inertes Gas unter einem totalen Gasdruck von mindestens 1 bar bei einer Sintertemperatur von mindestens 885 °C und höchstens 927 °C gesintert wird, indem das Ganze zunächst mit einer Geschwindigkeit von höchstens 50 °C/h auf 400 °C, dann mit einer solchen von höchstens 300 °C/h auf Sintertemperatur erhitzt, bei dieser während 30 min gehalten wird, wobei in der Schicht vorübergehend 0,1 bis 5 Vol.-% einer flüssigen Phase gebildet werden und das Ganze mit einer Geschwindigkeit von höchstens 100 °C/h auf 600 bis 400 °C abgekühlt, bei dieser Temperatur während 2 h gehalten und schliesslich mit einer Geschwindigkeit von höchstens 100 °C/h Raumtemperatur abgekühlt wird.

Vorzugsweise wird das Sintern unter 1 bar Druck in reiner $O_2$-Atmosphäre im Temperaturbereich von 915 bis 927 °C oder unter 1 bar Druck in Luft im Temperaturbereich von 885 bis 900 °C durchgeführt. Im allgemeinsten Fall wird das Substrat 3 aus Silber oder aus einer Silberlegierung vor der Herstellung der Oberflächenschicht 8 auf einen formbestimmenden und/oder mechanisch kraftschlüssigen Träger 6 aus einem von Silber oder einer Silberlegierung abweichenden Grundmaterial aufgebracht, wobei letzteres vorzugsweise aus einer warmfesten Legierung wie einer Nickelbasis-Super legierung, aus einem keramischen Stoff wie $SiO_2$, MgO, $ZrO_2$ oder aus einem Oxyd, Karbid oder Nitrid oder aus einem Halbleiter wie Si oder Ge besteht. Auf das Grundmaterial wird in vorteilhafter Weise zunächst eine Zwischenschicht 5 aus Cr, einer Cr/Ni-Legierung als Haftvermittler und/oder eine weitere Schicht 4 aus Pd aufgebracht. Gemäss spezieller Ausführungsart werden zwei pulverbeschichtete Substrate 3 mit der Schichtseite aufeinandergelegt, gepresst und nachfolgend gesintert.

Die Herstellung der Pulver aus $YBa_2Cu_3O_{6,5+y}$ sowie der Mischoxyde der ersten Pulverschicht 1 erfolgt vorteilhafterweise durch Mischen der stöchiometrischen Mengen der entsprechenden Metalloxalate oder Karbonate, Bereiten einer wässrigen Suspension dieser Stoffe, Zerkleinern der suspendierten Partikel, anschliessendes Trocknen der Suspension in einem Sprühtrockner, reagieren der pulvrigen Stoffmischung zu Pulvern der jweiligen Oxydverbindungen bei 700 °C bis 800 °C in einer Atmosphäre von $N_2$ + 10 Vol.-% $O_2$, wobei die Beschichtung dann aus einer kolloidalen Suspension der Pulver in eifner wasserfreien Flüssigkeit vorzugsweise durch Herausziehen des Substrates 3 aus der wasserfreien suspension mit kontrollierter Geschwindigkeit und durch kontrolliertes Trocknen in wasser- und $Co_2$-freier Atmosphäre durchgeführt wird. Nach einer Variante erfolgt die Beschichtung des Substrates 3 durch elektrophoretische Abscheidung der Pulverteilchen aus einer suspension in wasserfreier Flüssigkeit und anschliessendes kontrolliertes Trocknen in wasser- und $Co_2$-freier Atmosphäre.

Nach einem modifizierten Verfahren wird Cu teilweise durch mindestens eines der Elemente Fe, Ga, Al in einem totalen Gehalt von höchstens 2 Mol % ersetzt. Ausserdem wird in einer weiteren modifizierten Ausführung das Ba teilweise durch La in einem Gehalt von höchstens 20 Mol% ersetzt.

## Patentansprüche

1. Verfahren zur Herstellung einer polykristallinen, kristallorientierten Oberflächenschicht (8) auf einem Substrat (3) oder einer Zwischenschicht zwischen zwei Substraten (3), wobei die besagte Schicht aus einem keramischen Hochtemperatur-Supraleiter auf der Basis von $(Y,SE)Ba_2Cu_3O_{6,5+y}$ mit SE = seltenes Erdmetall und O<y<1 besteht, dadurch gekennzeichnet, dass als Substrat (3) reines metallisches Silber oder eine bis zu 20 Gew.-% Au oder Pd oder Pt enthaltende Silberlegierung benutzt und auf das besagte Substrat (3) eine aus den einfachen Oxyden und/oder Mischoxyden der Elemente Y, Ba, Cu oder den Oxyden der Elemente Y und Cu und dem Karbonat des Ba bestehende, dem stöchiometrischen Verhältnis Y:Ba:Cu:O = 1:2:3:6,5 entsprechende erste Pulverschicht (1) von höchstens 5 μm Dicke mit Partikeln von höchstens 2 μm Durchmesser aufgetragen und darauf eine zweite Pulverschicht (2) bestehend aus 1 bis 10 Mol % aus der vorgenannten Pulvermischung, Rest Pulver aus der supraleitenden Substanz $(Y,SE)Ba_2Cu_3O_{6,5+y}$ in einer Dicke von 5 bis 10 μm aufgebracht und das Ganze in einer Atmosphäre von mindestens 20 Vol.-% $O_2$, Rest $N_2$ oder ein inertes Gas unter einem totalen Gasdruck von mindestens 1 bar bei einer Sintertemperatur von mindestens 885 °C und höchstens 927 °C gesintert wird, indem das Ganze zunächst mit einer Geschwindigkeit von höchstens 50 °C/h auf 400 °C, dann mit einer solchen von höchstens 300 °C/h auf Sintertemperatur erhitzt, bei dieser während 30 min gehalten wird, wobei in der Schicht vorübergehend 0,1 bis 5 Vol.-% einer flüssigen Phase gebildet werden und das Ganze mit einer Geschwindigkeit von höchstens 100 °C/h auf 600 bis 400 °C abgekühlt, bei dieser Temperatur während 2 h gehalten und schliesslich mit einer Geschwindigkeit von höchstens 100 °C/h Raumtemperatur abgekühlt wird.

2. Verfahren nach Anspruch 1, dadurch gekennzeichnet, dass das Sintern unter 1 bar Druck in reiner $O_2$-

Atmosphäre im Temperaturbereich von 915 bis 927 °C durchgeführt wird.

3. Verfahren nach Anspruch 1, dadurch gekennzeichnet, dass das Sintern unter 1 bar Druck in Luft im Temperaturbereich von 885 bis 900 °C durchgeführt wird.

4. Verfahren nach Anspruch 1, dadurch gekennzeichnet, dass das Substrat (3) aus Silber oder aus einer Silberlegierung vor der Herstellung der Oberflächenschicht (8) auf einen formbestimmenden und/oder mechanisch kraftschlüssigen Träger (6) aus einem von Silber oder einer Silberlegierung abweichenden Grundmaterial aufgebracht wird.

5. Verfahren nach Anspruch 4, dadurch gekennzeichnet, dass das Grundmaterial aus einer warmfesten Legierung wie einer Nickelbasis-Superlegierung, aus einem keramischen Stoff wie $SiO_2$, MgO, $ZrO_2$ oder aus einem Oxyd, Karbid oder Nitrid oder aus einem Halbleiter wie Si oder Ge besteht.

6. Verfahren nach Anspruch 5, dadurch gekennzeichnet, dass auf das Grundmaterial zunächst eine Zwischenschicht (5) aus Cr, einer Cr/Ni-Legierung als Haftvermittler und/oder eine weitere Schicht (4) aus Pd aufgebracht wird.

7. Verfahren nach Anspruch 1, dadurch gekennzeichnet, dass zwei pulverbeschichtete Substrate (3) mit der Schichtseite aufeinandergelegt, gepresst und nachfolgend gesintert werden.

8. Verfahren nach Anspruch 1, dadurch gekennzeichnet, dass die Herstellung der Pulver aus $YBa_2Cu_3O_{6.5+y}$ sowie der Mischoxyde der ersten Pulverschicht (1) erfolgt vorteilhafterweise durch Mischen der stöchiometrischen Mengen der entsprechenden Metalloxalate oder Karbonate, Bereiten einer wässrigen Suspension dieser Stoffe, Zerkleinern der suspendierten Partikel, anschliessendes Trocknen der Suspension in einem Sprühtrockner, reagieren der pulvrigen Stoffmischung zu Pulvern der jeweiligen Oxydverbindungen bei 700 °C bis 800 °C in einer Atmosphäre von $N_2$ + 10 Vol.-% $O_2$.

9. Verfahren nach Anspruch 1, dadurch gekennzeichnet, dass die Beschichtung aus einer kolloidalen Suspension der Pulver in einer wasserfreien Flüssigkeit erfolgt.

10. Verfahren nach Anspruch 1, dadurch gekennzeichnet, dass die Beschichtung des Substrates (3) erfolgt durch Herausziehen des Substrates (3) aus einer wasserfreien Suspension mit kontrollierter Geschwindigkeit und durch kontrolliertes Trocknen in wasser- und $Co_2$-freier Atmosphäre.

11. Verfahren nach Anspruch 1, dadurch gekennzeichnet, dass die Beschichtung des Substrates (3) erfolgt durch elektrophoretische Abscheidung der Pulverteilchen aus einer Suspension in wasserfreier Flüssigkeit und anschliessendes kontrolliertes Trocknen in wasser- und $Co_2$-freier Atmosphäre.

12. Verfahren nach Anspruch 1, dadurch gekennzeichnet, dass Cu teilweise durch mindestens eines der Elemente Fe, Ga, Al in einem totalen Gehalt von höchstens 2 Mol % ersetzt ist.

13. Verfahren nach Anspruch 1, dadurch gekennzeichnet, dass Ba teilweise durch La in einem Gehalt von höchstens 20 Mol% ersetzt ist.

## Claims

1. Process for the production of a polycrystalline, crystal-oriented surface layer (8) on a substrate (3) or an interlayer between two substrates (3), where said layer consists of a ceramic high temperature superconductor based on (Y,RE) $Ba_2Cu_3O_{6.5+y}$ where RE = rare earth metal and $0 < y < 1$, characterised in that pure metallic silver or a silver alloy containing up to 20 % by weight of Au or Pd or Pt is used as the substrate (3), and a first powder layer (1) of a thickness of at most 5 $\mu$m with particles of diameter <2 $\mu$m, consisting of the simple oxides and/or mixed oxides of the elements Y, Ba, Cu or the oxides of the elements Y and Cu and the carbonate of Ba, corresponding to the stoichiometric ratio Y:Ba:Cu:O = 1:2:3:6.5, is applied to said substrate (3), and on it is applied a second powder layer (2), consisting of 1 - 10 mol% of the abovementioned powder mixture and the remainder powder of the superconducting substance (Y,RE) $Ba_2Cu_3O_{6.5+y}$, with a thickness of 5 - 10 $\mu$m, and the whole is sintered in an atmosphere of at least 20 % by volume $O_2$, remainder $N_2$ or an inert gas, under a total gas pressure of at least 1 bar at a sintering temperature of at least 885°C and at most 927°C, wherein the whole is first heated at a rate of at most 50°C/h to 400°C, then at a rate of at most 300°C/h to the sintering temperature, and held at this temperature for 30 minutes, whereupon a liquid phase of 0.1 - 5 % by volume is transitorily formed in the layer, and the whole is cooled at a rate of at most 100°C/h to 600 - 400°C, held at this temperature for 2 hours, and finally cooled at a rate of at most 100°C/h to room temperature.

2. Process according to Claim 1, characterised in that the sintering is carried out under a pressure of 1 bar in a pure $O_2$ atmosphere in the temperature range of 915 - 927°C.

3. Process according to Claim 1, characterised in that the sintering is carried out under a pressure of 1 bar in air in the temperature range of 885 - 900°C.

4. Process according to Claim 1, characterised in that the substrate (3) of silver or of a silver alloy is applied before the production of the surface layer (8) to a shape-determining and/or mechanically non-positive support (6) of a base material other than silver or a silver alloy.

5. Process according to Claim 4, characterised in that the base material is a heat-resistant alloy such as a nickel-base superalloy, or a ceramic material such as $SiO_2$, $MgO$, $ZrO_2$, or an oxide, carbide or nitride or a semiconductor such as Si or Ge.

6. Process according to Claim 5, characterised in that an interlayer (5) of Cr, a Cr/Ni alloy as adhesion promoter, and/or a further layer (4) of Pd is first applied to the base material.

7. Process according to Claim 1, characterised in that two powder-coated substrates (3) are superposed with the coated sides together, pressed, and subsequently sintered.

8. Process according to Claim 1, characterised in that the preparation of the powder of $YBa_2Cu_3O_{6.5+y}$ and of the mixed oxides of the first powder layer (1) advantageously takes place by mixing the stoichiometric amounts of the corresponding metal oxalates or carbonates, forming an aqueous suspension of these materials, comminution of the suspended particles, subsequent drying of the suspension in a spray drier, and reacting the pulverulent mixture of materials to form powders of the respective oxide compounds at 700°C - 800°C in an atmosphere of $N_2$ + 10 % by volume $O_2$.

9. Process according to Claim 1, characterised in that the coating takes place from a colloidal suspension of the powder in a water-free liquid.

10. Process according to Claim 1, characterised in that the coating of the substrate (3) takes place by pulling the substrate (3) out of a water-free suspension at a controlled speed and by controlled drying in an atmosphere free from water and $CO_2$.

11. Process according to Claim 1, characterised in that the coating of the substrate (3) takes place by electrophoretic deposition of the powder particles from a suspension in a water-free liquid and subsequent controlled drying in an atmosphere free from water and $CO_2$.

12. Process according to Claim 1, characterised in that the Cu is partially substituted by at least one of the elements Fe, Ga, Al in a total content of at most 2 mol%.

13. Process according to Claim 1, characterised in that Ba is partially substituted by La in a content of at most 20 mol%.

## Revendications

1. Procédé de préparation d'une couche superficielle (8) polycristalline à cristaux orientés sur un substrat (3) ou d'une couche intermédiaire entre deux substrats (3), étant entendu que la couche en question consiste en un supraconducteur céramique à haute température à base de (Y, TR) $Ba_2Cu_3O_{6.5+y}$, où TR = métal des terres rares et $0 < y < 1$, caractérisé en ce qu'on utilise, comme substrat (3), de l'argent métallique pur ou un alliage d'argent contenant jusqu'à 20% en poids d'Au ou de Pd ou de Pt et que sur ledit substrat (3), on applique une première couche de poudre (1) consistant en les oxydes simples et/ou les oxydes mixtes des éléments Y, Ba, Cu ou en les oxydes des éléments Y et Cu et en le carbonate de Ba, correspondant au rapport stoechiométrique Y:Ba:Cu:O = 1:2:3:6,5, d'une épaisseur de 5 μm au maximum contenant des particules d'un diamètre de 2 μm au maximum et on applique par-dessus, une deuxième couche de poudre (2) consistant en 1 à 10 moles % du mélange de poudres précité et pour le reste de la poudre en la substance supraconductrice (Y, TR) $Ba_2Cu_3O_{6,5+y}$ en une épaisseur de 5 à 10 μm et on fritte le tout dans une atmosphère d'au moins 20% en volume de $O_2$ et pour le reste de $N_2$, ou d'un gaz inerte sous une pression gazeuse totale d'au moins 1 bar à une température de frittage d'au moins 885°C et au maximum de 927°C, en chauffant le tout d'abord à une vitesse de 50°C par heure au maximum jusqu'à 400°C, puis à une vitesse de 300°C par heure au maximum jusqu'à la température de frittage en le maintenant à cette dernière pendant 30 minutes, au cours desquelles il se forme transitoirement 0,1 à 5% en volume d'une phase liquide et en refroidissant le tout à une vitesse de 100°C par heure au maximum jusqu'à 600 à 400°C, en le maintenant à cette température pendant 2 heures et en le refroidissant finalement à une vitesse de 100°C par heure au maximum jusqu'à la température ambiante.

2. Procédé suivant la revendication 1, caractérisé en ce que le frittage est exécuté sous une pression de 1 bar dans une atmosphère de $O_2$ pur dans l'intervalle de température de 915 à 927°C.

3. Procédé suivant la revendication 1, caractérisé en ce que le frittage est exécuté sous une pression de 1 bar dans l'air dans l'intervalle de température de 885 à 900°C.

4. Procédé suivant la revendication 1, caractérisé en ce que le substrat (3) d'argent ou d'un alliage d'argent est appliqué, avant la préparation de la couche superficielle (8), sur un support (6) à détermination de forme et/ou à transfert de force mécanique consistant en une matière de base différente de l'argent ou d'un alliage d'argent.

5. Procédé suivant la revendication 4, caractérisé en ce que la matière de base consiste en un alliage résistant à la chaleur tel qu'un superalliage à base de nickel, en une substance céramique telle que le $SiO_2$, le MgO, le $ZrO_2$ ou en un oxyde, carbure ou nitrure ou en un semi-conducteur tel que le Si ou Ge.

6. Procédé suivant la revendication 5, caractérisé en ce qu'il est d'abord appliqué, sur la matière de base, une couche intermédiaire (5) de Cr, d'un alliage Cr/Ni comme intermédiaire d'adhérence et/ou une couche supplémentaire (4) de Pd.

7. Procédé suivant la revendication 1, caractérisé en ce que deux substrats (3) revêtus de poudre sont superposés par la face revêtue, pressés et ensuite frittés.

8. Procédé suivant la revendication 1, caractérisé en ce que la préparation de la poudre de $YBa_2Cu_3O_{6,5+y}$ ainsi que des oxydes mixtes de la première couche de poudre (1) a lieu de préférence par mélange des quantités stoechiométriques des oxalates ou carbonates métalliques correspondants, préparation d'une suspension aqueuse de ces substances, broyage des particules en suspension, puis séchage de la suspension dans un séchoir par pulvérisation, réaction du mélange de substances pulvérulentes en poudres des oxydes correspondants à 700°C jusqu'à 800°C dans une atmosphère de $N_2$ + 10% en volume de $O_2$.

9. Procédé suivant la revendication 1, caractérisé en ce que le revêtement à partir d'une suspension colloïdale de la poudre est exécuté dans un liquide exempt d'eau.

10. Procédé suivant la revendication 1, caractérisé en ce que le revêtement du substrat (3) est exécuté par extraction du substrat (3) hors d'une suspension exempte d'eau à une vitesse contrôlée et par séchage contrôlé dans une atmosphère exempte d'eau et de $CO_2$.

11. Procédé suivant la revendication 1, caractérisé en ce que le revêtement du substrat (3) est exécuté par dépôt électrophorétique des particules de la poudre à partir d'une suspension dans un liquide exempt d'eau, puis par séchage contrôlé dans une atmosphère exempte d'eau et de $CO_2$.

12. Procédé suivant la revendication 1, caractérisé en ce que le Cu est remplacé partiellement par au moins un des éléments Fe, Ga et Al en une teneur totale de 2 moles % au maximum.

13. Procédé suivant la revendication 1, caractérisé en ce que le Ba est remplacé partiellement par La en une teneur de 20 moles % au maximum.

# FIG.1

**Ag - Band 0,05 mm dick**

↓

Aufbringen einer Suspension von $Y/Ba_2/Cu_3-$ Mischoxyd — Pulver

↓

Trocknen

↓

Aufbringen einer Suspension von $YBa_2Cu_3O_7$ — Pulver + Y/Ba /Cu — Mischoxyd - Pulver

↓

Trocknen

↓

Erwärmen auf 923°C in $O_2$ mit einer Geschwindigkeit $< 50\ °C/h$

↓

Sintern bei 923°C/30min

↓

Abkühlen auf 500°C in $O_2$ mit einer Geschwindigkeit von 100°C/h

↓

Halten bei 500°C/2h

↓

Abkühlen auf Raumtemperatur in $O_2$ mit einer Geschwindigkeit von 100°C/h

↓

**Hochtemperatur - Supraleiter mit Kristallorientierung**

C-Achse $\perp$ Substratoberfläche

# FIG.2

# FIG.3